(19) **Europäisches Patentamt European Patent Office Office européen des brevets**

(11) **EP 3 627 536 B1**

(12) # EUROPEAN PATENT SPECIFICATION

(45) Date of publication and mention of the grant of the patent:
**27.07.2022 Bulletin 2022/30**

(21) Application number: **18868072.2**

(22) Date of filing: **05.10.2018**

(51) International Patent Classification (IPC):
*H01L 21/205* (2006.01)    *C01B 32/21* (2017.01)
*C23C 16/42* (2006.01)    *C23C 16/46* (2006.01)
*H01L 21/683* (2006.01)

(52) Cooperative Patent Classification (CPC):
**H01L 21/68757; C01B 32/21; C23C 16/4581;
C23C 16/4584; C23C 16/4586; C23C 16/46;
H01L 21/67103; H01L 21/67115; H01L 21/67248**

(86) International application number:
**PCT/JP2018/037342**

(87) International publication number:
**WO 2019/078036 (25.04.2019 Gazette 2019/17)**

(54) **SUSCEPTOR**

SUSZEPTOR

SUSCEPTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.10.2017 JP 2017201582**

(43) Date of publication of application:
**25.03.2020 Bulletin 2020/13**

(73) Proprietor: **Nippon Techno-Carbon Co., Ltd.
Miyagi 981-3514 (JP)**

(72) Inventors:
• **OKUBO Shuichi
Kurokawa-gun
Miyagi 981-3514 (JP)**
• **TAKAHASHI Hikari
Kurokawa-gun
Miyagi 981-3514 (JP)**
• **SUZUKI Toshiya
Kurokawa-gun
Miyagi 981-3514 (JP)**
• **USUBA Hidehiko
Kurokawa-gun
Miyagi 981-3514 (JP)**

(74) Representative: **Beckmann, Claus
Kraus & Weisert
Patentanwälte PartGmbB
Thomas-Wimmer-Ring 15
80539 München (DE)**

(56) References cited:
EP-A- 0 235 570        EP-A1- 1 790 757
CN-A- 106 948 002      JP-A- H07 165 467
JP-A- H07 165 467      JP-A- 2001 031 473
JP-A- 2001 031 473     JP-A- 2016 012 679
JP-A- 2017 103 190     JP-A- 2018 145 079
KR-A- 20090 125 347    US-A1- 2015 206 785
US-B1- 6 740 167

**Description**

[Technical Field]

The present invention relates to a susceptor which is used in manufacturing fields of LEDs (light-emitting diodes), power devices, and the like, in a CVD apparatus for epitaxially growing a semiconductor coating on a wafer, on which a wafer is mounted, and which generates heat by induction heating.

[Background Art]

Compound semiconductors such as GaN and SiC in addition to Si are known as epitaxially growing semiconductor coatings, and an epitaxial growth apparatus capable of mounting a plurality of wafers on a large-size susceptor and subjecting the wafers to a heating process of up to 1600°C for the purpose of cost reduction has been proposed (PTL 1).

A susceptor for mounting a wafer is installed in the epitaxial growth apparatus, the wafer is heated by heat transfer from the susceptor having generated heat due to induction heating, and a wafer product is manufactured by forming a semiconductor coating on the wafer using an MOCVD method (metalorganic chemical vapor deposition). The wafer product on which the semiconductor coating is formed is cut into chips of a certain size depending on the intended use and provided as semiconductor parts of an LED or a power device.

A wafer product provided for a white LED is generally manufactured by mounting a sapphire substrate on a susceptor and heating the sapphire substrate, and forming a GaN coating by allowing hydrogen as a carrier gas, ammonia as a raw material gas, and TMG (trimethyl gallium) to flow on the sapphire substrate. For produce functions as an LED, an Al-doped buffer layer, a Si-doped n-type layer, an In-doped active layer, and an Mg-doped p-type layer, for example, are laminated in this order in this wafer product (PTL 2).

Quality can be maintained by forming the GaN coatings with different components by heating the wafer at an optimum temperature, and productivity can be maintained by promptly regulating susceptor temperature every time each coating is laminated.

A graphite base material having heat resistance and electrical conductivity is adopted as the susceptor so that temperature can be promptly regulated, and the susceptor generates heat by induction heating. In addition, the epitaxial growth apparatus is designed to make a temperature distribution of the susceptor uniform by providing a plurality of induction heating coils and dividing a heat generation zone or rotating and driving the susceptor with respect to an induction heating coil.

EP 1 790 757 A1 describes a susceptor capable of obtaining high-quality SiC semiconductor crystals by keeping the Si concentration and C concentration around a wafer constant and by preventing the generation of particles. The susceptor of graphite covered with silicon carbide is characterized in that at least one section of a part on which a wafer is placed is tantalum carbide or a graphite material covered with tantalum carbide. The part on which the wafer is placed may be a detachable member. A material around the part on which the wafer is placed may be a detachable graphite material covered with silicon carbide.

JP H07 165467 A relates to the problem to provide a method for producing isotropic graphite material suitable as a crucible for pulling up silicon single crystals and having both of low coefficient of thermal expansion and excellent gas impermeability. As a solution to the problem, the document describes that 50 - 95 parts by weight of acicular fine powder having $\leq$ 15 $\mu$m average particle diameter is blended with 50 - 5 wt.% of natural graphite fine powder having $\leq$ 30 $\mu$m average particle diameter to give a filler raw material and this filler raw material is subjected to kneading treatment with a pitch-based binder and then, the kneaded material is pulverized and the pulverized fine powder is formed by isostatic press and subjected to baking and carbonization and subjected to graphitization treatment. Thereby, isotropic graphite material having 2.3 - 3.8 $\times$ 10$^{-6}$/ °C average thermal expansion from room temperature to 1000 °C and 0.5 - 15 $\times$ 10$^{-2}$ cm$^2$/sec gas permeability is produced.

[Citation List]

[Patent Literature]

[PTL 1] Japanese Translation of PCT Application No. 2004-507619

[PTL 2] Japanese Patent Application Publication No. 2004-281863

[Summary of Invention]

However, even when the epitaxial growth apparatus is designed for uniform heating precise temperature control cannot be realized unless characteristics of electrical resistivity of the graphite base material constituting the susceptor can be optimized since heat generation characteristics of the susceptor directly affects wafer temperature in the case of induction heating. The susceptor is required to promptly regulate wafer temperature in order to laminate semiconductor coatings on the wafer within a limited process time and, from the perspectives of quality and productivity of wafer products, the susceptor is required to have preferable responsiveness with respect to temperature control.

Meanwhile, the electrical resistivity of the graphite base material has temperature dependence. Unless the electrical resistivity of the graphite base material conforms to a temperature change that accompanies induction heating, it is difficult to perform temperature control with good responsiveness and a decline in quality of wafer products due to a deviation from an optimum temperature and a drop in productivity caused by an increase in process time occur. In addition, when there may be a large variation in an electrical resistivity distribution of the graphite base material, a variation in heat generation occurs and a temperature difference within a susceptor plane increases and, consequently, problems in durability such as breakage of the susceptor due to thermal stress occur.

The present invention provides a susceptor with improved responsiveness of temperature control by conforming electrical resistivity of a graphite base material under high temperature with respect to induction heating, and an object thereof is to obtain a high-quality wafer product without hindering productivity.

The present invention provides the susceptor defined in claim 1.

At least one material among SiC, TaC, and PBN (pyrolytic boron nitride) is suitable as the ceramic coating layer described above.

According to the present invention, since temperature responsiveness of a susceptor due to induction heating is high, temperature control can be performed precisely and promptly, and both an improvement in quality of wafer products and an improvement in productivity due to reduced process time can be achieved.

[Brief Description of Drawings]

[Fig. 1]

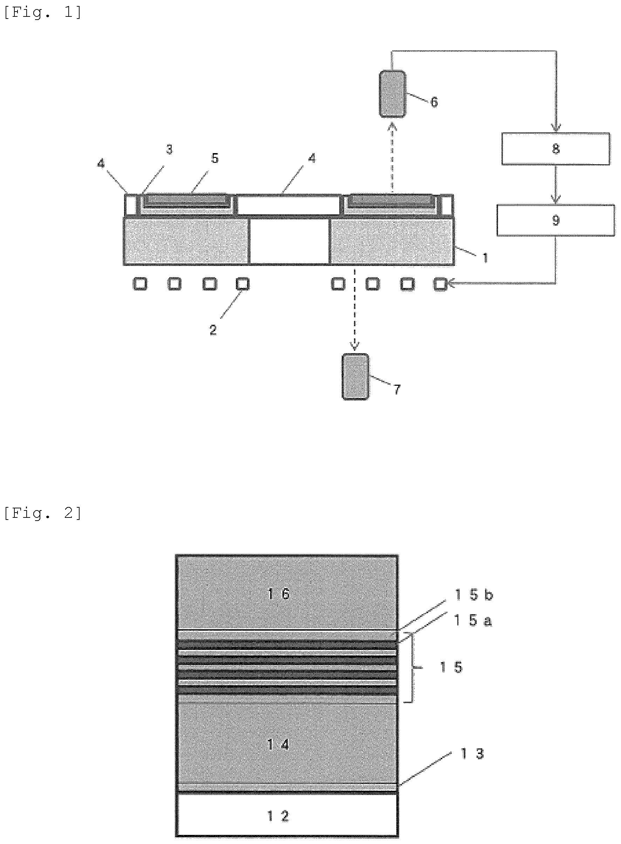

Fig. 1 is a schematic view of a susceptor inside an apparatus.
[Fig. 2]
Fig. 2 is a schematic sectional view of a wafer product.
[Fig. 3]

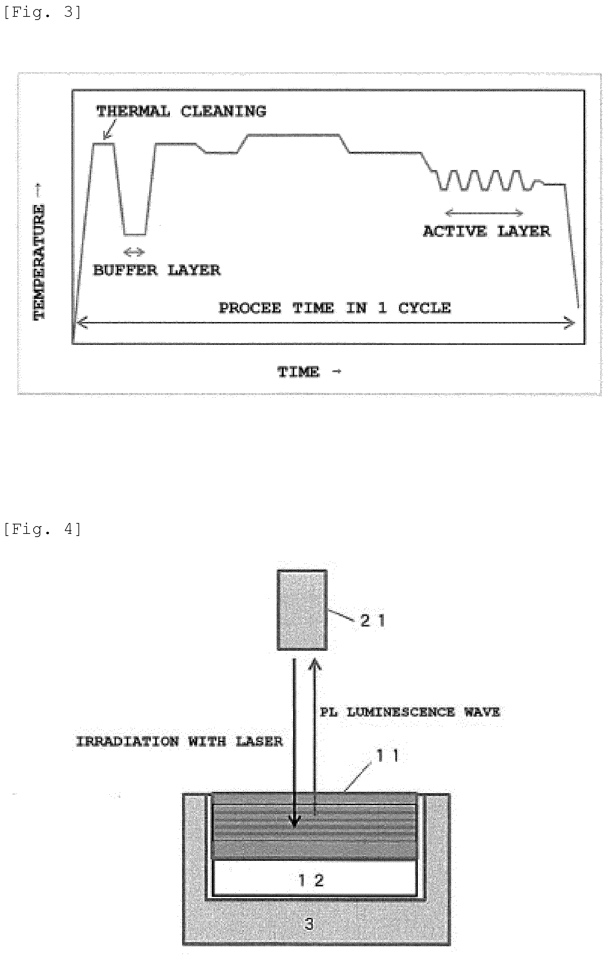

Fig. 3 shows a temperature program when manufacturing a wafer product.
[Fig. 4]
Fig. 4 is a schematic view of quality evaluation of a wafer product.
[Fig. 5]

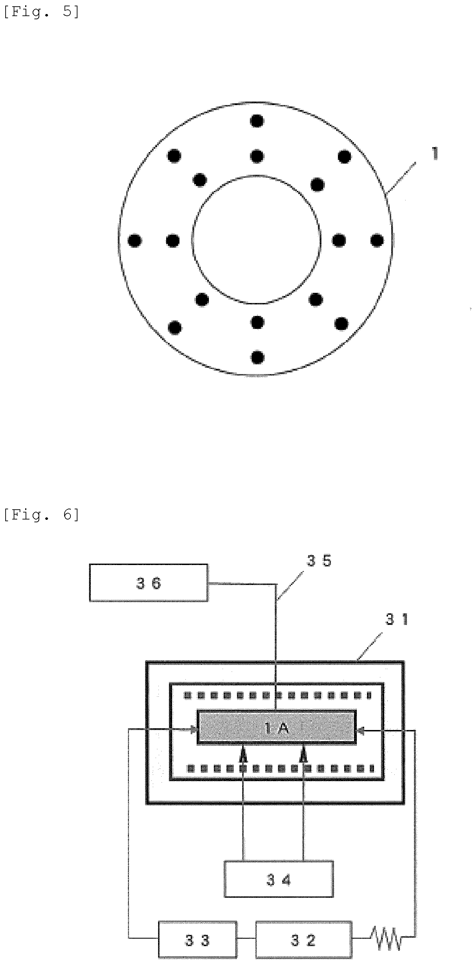

Fig. 5 shows measurement locations of in-plane electrical resistivity of a graphite base material.
[Fig. 6]
Fig. 6 is a schematic view of a high-temperature electrical resistivity measurement apparatus.
[Fig. 7]

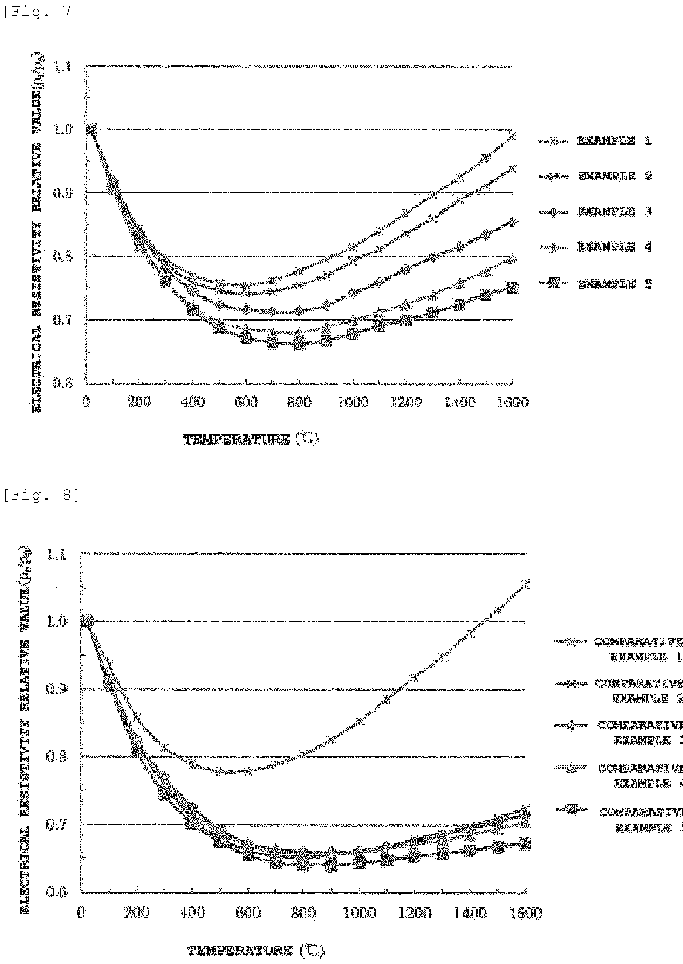

Fig. 7 shows temperature dependence of electrical resistivity of a graphite base material according to examples of the present invention.
[Fig. 8]
Fig. 8 shows temperature dependence of electrical resistivity of a graphite base material according to comparative examples of the present invention.

[Description of Embodiments]

A susceptor according to the present invention is a susceptor as defined in claim 1 which generates heat by induction heating and which includes a graphite base material and a ceramic coating layer. In addition, a variation $(\rho_{max}/\rho_{min})$ of an in-plane electrical resistivity distribution of the graphite base material at room temperature ranges from 1.00 to 1.05, and a rate of high-temperature change $(\rho_{1600}/\rho_{800})$ of electrical resistivity at 1600°C to that at 800°C of 1.14 to 1.30.

According to the present invention, by setting a variation $(\rho_{max}/\rho_{min})$ of the in-plane electrical resistivity distribution of the graphite base material at room temperature so as to be from 1.00 to 1.05, heat generation in a susceptor plane becomes uniform with respect to induction heating and temperature in the susceptor plane becomes uniform.

As a result, a plurality of mounted wafers can be heated at a same temperature and a variation in quality among wafer products can be eliminated. In addition, by making the temperature in the susceptor plane uniform, problems of durability can also be solved such as avoiding breakage of the susceptor due to thermal stress.

Although the absence of a variation realizes most uniform in-plane heat generation when $\rho_{max}/\rho_{min}$ is 1.00, once $\rho_{max}/\rho_{min}$ exceeds 1.05, an increase in a difference in temperature distribution in the plane prevents the plurality of mounted wafers from being set to a same temperature and causes quality of wafer products to vary. In addition, since the variation in temperature distribution in the susceptor plane is excessive, there may be cases where thermal stress is generated in the susceptor and causes damage to a ceramic coating (a ceramic coating layer) or local abnormal overheating due to a concentration of eddy currents causes the ceramic coating to thermally decompose.

Setting a rate of high-temperature change ($\rho_{1600}/\rho_{800}$) of the electrical resistivity of the graphite base material so as to be from 1.14 to 1.30 improves temperature responsiveness of the susceptor according to the present invention with respect to induction heating and enables temperature control of the susceptor to be performed precisely and promptly.

Electrical resistivity ($\rho_t$) at high temperature of the graphite base material can be obtained by multiplying a ratio $R_t/R_0$ of a resistance value $R_t$ actually measured at high temperature (800°C and 1600°C) and a resistance value $R_0$ at room temperature by electrical resistivity $\rho_0$ actually measured at room temperature.

High-temperature electrical resistivity $\rho_t = \rho_0 (R_t/R_0)$

In addition, the rate of high-temperature change ($\rho_{1600}/\rho_{800}$) of the electrical resistivity at 1600°C to that at 800°C can be calculated using resistance values ($R_{1600}$ and $R_{800}$) at 800°C and 1600°C.

With respect to the temperature dependence of electrical resistivity of the graphite material, it is generally known that electrical resistivity decreases from room temperature to around 600°C to 800°C, and after reaching a local minimum near 600°C to 800°C, electrical resistivity linearly increases with a rise in temperature, and the larger a size of a crystallite of the graphite material (the higher a crystalline nature of the graphite material), the larger a gradient of the straight line (TANSO, No. 268, 166-170, 2015).

In a temperature region (800°C or higher) where wafer products are manufactured, the electrical resistivity of the graphite base material increases linearly with a rise in temperature, and the present invention was made on the basis of discovering that the rate of high-temperature change ($\rho_{1600}/\rho_{800}$) at this point affects responsiveness of temperature control of the susceptor. While a reason therefor is not clear and obvious, the following reason is conceivable.

In a susceptor installed in an epitaxial growth apparatus, when power is supplied to an induction heating coil in a lower part of the susceptor, eddy currents are generated in a graphite base material and heat is generated by Joule heat (Joule's law).

$$\text{Joule heat (P)} = \text{eddy current (I)} \times \text{eddy current (I)} \times \text{electrical resistance (R)}$$

The electrical resistance (R) of the susceptor is designed on the basis of heat treating capacity of the epitaxial growth apparatus, and electrical resistivity of the graphite base material appropriate to the electrical resistance (R) is selected. Since electrical resistance (R) is correlated with the electrical resistivity ($\rho$) of the graphite base material, the term of electrical resistance can be handled in a similar manner to electrical resistivity.

By adjusting power supplied to the induction heating coil, the eddy current (I) changes and the susceptor can control temperature. Once the temperature of the susceptor starts to rise, since the electrical resistivity of the graphite base material also starts to rise simultaneously at 800°C or higher, both the eddy current (I) and the electrical resistance (R) contribute to raising the temperature of the susceptor. For this reason, the higher the rate of high-temperature change ($\rho_{1600}/\rho_{800}$) of electrical resistivity, the larger the electrical resistance (R) of the susceptor due to temperature rise, which causes an increase in Joule heat (P) and promotes temperature rise. Therefore, temperature responsiveness of the susceptor conceivably improves because the temperature rise of the susceptor occurs earlier than readjusting power of the induction heating coil.

Since the temperature responsiveness due to induction heating of the susceptor according to the present invention improves, prompt temperature regulation can be performed with respect to a target temperature, and by minimizing a waiting time for temperature stabilization, high-quality wafer products can be obtained without impairing productivity.

While a higher rate of high-temperature change ($\rho_{1600}/\rho_{800}$) promotes temperature rise and improves temperature responsiveness, when higher than 1.30, hunting of temperature when approaching the target temperature is more likely to occur and more time is required to settle at a constant temperature. Therefore, an upper limit of $\rho_{1600}/\rho_{800}$ according to the present invention is set to 1.30.

On the other hand, when the rate of high-temperature change ($\rho_{1600}/\rho_{800}$) is lower than 1.14, temperature responsiveness of the susceptor declines. In this case, an increase in electrical resistivity that accompanies temperature rise is small, and since eddy currents due to power adjustment of the induction heating coil mainly contributes to heat generation, temperature responsiveness of the susceptor declines and more time is required before stabilizing at a target temperature. Since wafer products are manufactured by being repetitively regulated to different temperatures, when the rate of high-temperature change ($\rho_{1600}/\rho_{800}$) is lower than 1.14, the time required for 1 cycle increases and productivity of the wafer products declines.

Since the susceptor is exposed at a high temperature to an etching gas such as hydrogen and ammonia, a surface of the susceptor is coated by a ceramic coating with superior corrosion resistance in order to prevent rapid depletion of the graphite base material. The ceramic coating layer can be selected from at least one material among SiC (silicon carbide), TaC (tantalum carbide), and PBN (pyrolytic boron nitride), and the surface of the graphite base material can be coated using a general CVD method.

An example of a manufacturing method of a wafer product will be described with reference to Fig. 1. Fig. 1 is a schematic view of a case where a wafer product is manufactured by installing a susceptor in an epitaxial growth apparatus.

A susceptor 1 according to the present invention can be installed above an induction heating coil 2 provided inside the apparatus, and when power is supplied to the induction heating coil, the susceptor 1 generates heat by induction heating. A wafer holder 3 and a protective member 4 are installed on an upper surface of the susceptor 1 and are heated by heat transfer from the susceptor 1 generating heat. A pocket for holding a wafer 5 is formed in the wafer holder 3, and the wafer holder 3 heats the wafer 5 mounted to the pocket by heat transfer. The wafer holder 3 and the protective member 4 are generally made of a same material as the susceptor 1.

Although the wafer 5 and the susceptor 1 are capable of measuring temperature using respective radiation thermometers 6 and 7, for the purpose of quality control of wafer products, the wafer products are desirably manufactured by managing the temperature of wafers with the radiation thermometer 6. Since the temperature of the wafer 5 is regulated by heat transfer from the susceptor 1, naturally, the temperature of the susceptor 1 needs to be set higher than the temperature of the wafer 5.

A temperature regulator 8 of induction heating senses a wafer temperature measured by the radiation thermometer 6, sends a signal to an induction heating power supply on the basis of a temperature program set in advance, and adjusts power of the induction heating coil. Due to the radiation thermometer 6 feeding back a change in wafer temperature after the power adjustment to the temperature regulator 8, the power of the induction heating coil is readjusted and temperature control is realized.

As described above, responsiveness of temperature control of the epitaxial growth apparatus is primarily determined by device performances of the temperature regulator 8, an induction heating power supply 9, and the induction heating coil 2.

A carrier gas and a raw material gas are allowed to flow inside a space above the wafer, and a wafer product is manufactured by laminating semiconductor coatings by an MOCVD method on top of the heated wafer 5.

Fig. 2 is a schematic sectional view showing an example of a wafer product 11 manufactured using the susceptor according to the present invention. A first layer on a sapphire substrate 12 is an AlGaN buffer layer 13 in which GaN is doped with Al, and an n-type GaN layer 14 doped with Si, an active layer 15 with a multi-quantum well structure in which an InGaN well layer 15a doped with In and an undoped GaN barrier layer 15b are alternately laminated, and a p-type GaN layer 16 doped with Mg are laminated in this order.

Fig. 3 shows a pattern of a temperature program representing an example of manufacturing a wafer product using the susceptor according to the present invention. For example, when heating temperature of a wafer is controlled within a range of around 600°C to 1100°C, the susceptor generates heat at a temperature that is higher by around 100°C to 200°C.

Induction heating is started when a sapphire substrate is mounted to the susceptor. First, in order to clean a surface of the sapphire substrate, heat treatment known as thermal cleaning is performed at high temperature without supplying a raw material gas. Next, coatings are laminated while sequentially performing temperature control for laminating the respective GaN layers constituting the wafer product, and the wafer product is manufactured within a determined process time of 1 cycle.

Quality of the GaN coatings laminated on the sapphire substrate (wafer) can be evaluated by an optical analysis method utilizing a photoluminescence method (PL method).

For example, when the wafer product is irradiated by a laser beam, an electron-hole pair is generated near a band gap unique to the semiconductor, and light is emitted when the electron and the hole recombine. By measuring a luminescence spectrum thereof, the band gap, a crystalline nature, a doping amount, and the like can be evaluated. (11th Nitride Semiconductor Application Workshop, "Observation of Nitride Crystal Growth using In-situ Monitor", 2011.7.7)

Fig. 4 is a schematic view of a method of measuring a wavelength (PL wavelength) of a luminescence spectrum when the wafer product 11 is irradiated with a laser beam from a PL analyzer 21 mounted to the epitaxial growth apparatus.

Analysis of a wafer product is performed by scanning an entire wafer surface with the laser beam at minute intervals and measuring PL wavelengths corresponding to locations with respect to an entire surface of a semiconductor coating. Quality evaluation of the wafer product is performed using an average value and a standard deviation (STD) obtained by statistically processing PL wavelengths measured over the entire wafer surface.

The average value of PL wavelengths obtained for each wafer is to be used as, for example, an index for determining whether or not the wafer meets a wavelength standard of an LED that differs from one product to the next, and in the present invention, a wafer within ±3 nm of a target PL wavelength is deemed acceptable.

The STD to be used as an index of variation obtained for each wafer affects an amount of LED chips to be obtained as non-defective items from one wafer product. Since the smaller the STD value, the smaller the variation in PL wavelengths, a determination is made that the quality of the wafer product is good. In the present invention, a wafer with an STD of less than 2 nm is deemed acceptable.

Fig. 5 shows locations where in-plane electrical resistivity was measured with respect to the graphite base material in the susceptor schematic view used as an example of the present invention. In-plane electrical resistivity can be measured using a four probe method in a non-destructive manner at 16 locations (● marks) on a surface of the graphite base material.

A variation ($\rho_{max}/\rho_{min}$) of an electrical resistivity distribution can be indexed by a ratio of a maximum value ($\rho_{max}$) to a minimum value ($\rho_{min}$) measured at a plurality of locations of the graphite base material. An average value ($\rho_{av}$) is obtained by averaging the measured electrical resistivity of the 16 locations.

Fig. 6 shows a schematic view of an apparatus that measures high-temperature electrical resistance.

A measurement of high-temperature electrical resistance is performed by setting a graphite sample 1A ($\phi$10 × 100 mm) cut out from the graphite base material to an electric furnace 31, connecting a DC power supply 32 to terminals attached to both ends of the graphite sample 1A while heating the graphite sample 1A from room temperature up to 1600°C, and measuring a current value and a voltage drop value using an ammeter 33 and a potentiometer 34. Temperatures are measured using a temperature recorder 36 by directly attaching a thermocouple 35 to a center of the graphite sample 1A. A resistance value $R_t$ at each temperature is calculated using the current value and the voltage drop value measured at this point.

While a manufacturing method of a graphite base material used in the susceptor according to the present invention will now be described, the manufacturing method is not limited to the method described below.

Preferably, a graphite material can be obtained by preparing the graphite material by cold isostatic pressing (CIP) and machining the graphite material into a shape of the susceptor.

Since the graphite material used in the present invention desirably has a large graphite crystallite size and a high graphite crystalline nature, an acicular coke powder or a pulverized powder of artificial graphite manufactured using an acicular coke powder, a natural graphite powder, or the like is used as a raw material aggregate. In addition, by blending an amorphous coke powder with the aggregate, physical properties of the graphite material can be adjusted. The aggregate raw material used in the present invention preferably uses a mixture of two or more of these materials. For example, a mixed raw material constituted by 30 to 80 parts by weight of an amorphous coke powder and 20 to 70 parts by weight of an acicular coke powder is preferable. A mixed raw material constituted by 50 to 80 parts by weight of an amorphous coke powder and 20 to 50 parts by weight of a graphite powder is also preferable.

While the aggregate is used by pulverizing the aggregate to a prescribed particle size, in the present invention, preferably, particle sizes are distributed within a range of 1 to 200 $\mu$m and a mean particle size (a median particle size $D_{50}$) does not exceed 20 $\mu$m. In particular, since an acicular coke powder has an effect of increasing the size of crystallites of the graphite base material (increasing a crystalline nature of the graphite material), performing particle size control to coarse particles by removing a fine powder in a classification operation after pulverization or making the mean particle size larger than 20 $\mu$m has a risk of making the rate of high-temperature change ($\rho_{1600}/\rho_{800}$) of the graphite base material excessive. The mean particle size preferably ranges from 5 to 15 $\mu$m.

After heating and kneading the aggregate described above together with a bonding material (tar, pitch, or the like) at a prescribed blending ratio, the aggregate is cooled to near room temperature and pulverized by a pulverizer. The pulverized powder is packed into a rubber case and sealed, and subsequently pressurized by a CIP molding machine to obtain a compact.

The obtained compact is subjected to heat treatment up to 1000°C in a non-oxidizing atmosphere to be fired and carbonized. If necessary, the fired body can be impregnated with a thermally melted pitch for impregnation and then fired once again. Performing pitch impregnation increases bulk density and strength while reducing electrical resistivity of the obtained graphite material.

By subjecting the obtained fired body to heat treatment within a range of 2800°C to 3000°C in a graphitizing furnace to graphitize the fired body, a graphite material can be obtained. Since the higher a graphitization temperature, the larger the size of graphite crystallites and the higher the crystalline nature, a heat treatment temperature is desirably set to 3000°C.

In order to suppress a variation in the electrical resistivity distribution of the graphite base material, graphitization may be performed at a uniform heat treatment temperature. Generally, although an Acheson furnace or a high frequency induction furnace is used as the graphitizing furnace, since the larger the size of the graphite base material, the larger the variation in the electrical resistivity distribution, a high frequency induction furnace rather than an Acheson furnace is desirably used.

To determine physical property values of the graphite base material, a test piece TP ($10 \times 10 \times 50$ mm) was cut out from an arbitrary location of the graphite base material and bulk density, a coefficient of thermal expansion, flexural strength, and electrical resistivity were measured.

The bulk density was calculated by actually measuring a weight and a volume of the test piece. The coefficient of thermal expansion was calculated by measuring a coefficient of linear expansion when the test piece is heated from room temperature to 500°C using a commercially-available thermal analysis instrument equipped with a differential transformer. The flexural strength was calculated by measuring a maximum load upon breakdown when setting a distance between fulcrums to 40 mm and a load velocity to 0.5 mm/min using JIS R 7222: 1997 (Test Methods for Physical Properties of Graphite Materials) as a reference. The electrical resistivity was measured by a voltage drop method according to JIS R 7222: 1997 (Test Methods for Physical Properties of Graphite Materials).

The graphite base material that can be used as a susceptor has a bulk density of 1.70 to 1.80 g/cm$^3$, a coefficient of thermal expansion of 3.5 to 4.5 $\times$ 10$^{-6}$/K, a flexural strength of 35 to 60 MPa, and electrical resistivity ($\rho_0$) ranging from 8.0 to 13.0 $\mu\Omega$m.

(Ceramic coating layer)

The susceptor according to the present invention is a graphite base material having been obtained by machining a graphite material into the shape of the susceptor and preferably being coated with a ceramic coating by a CVD method.

The ceramic coating layer is desirably at least one material among SiC, TaC, and PBN. In particular, two or more layers of a same material or different materials are preferably laminated. A thickness of the ceramic coating layer preferably ranges from 50 to 200 $\mu$m.

Since the susceptor is exposed to reactive gas such as NH$_3$ or H$_2$ at high temperature, the susceptor becomes repeatedly usable by being coated with the ceramic coating described above having superior corrosion resistance with respect to such gases.

A method of coating the surface of the graphite base material with a ceramic coating is a known method using a CVD method.

Examples

Hereinafter, while the present invention will be described in specific terms based on embodiments, it is to be understood that the susceptor according to the present invention is not limited by contents of the embodiments.

Example 1

As aggregate raw materials, aggregates respectively having a mean particle size of 15 $\mu$m were obtained by individually pulverizing amorphous coke and acicular coke down to a maximum particle size of 200 $\mu$m with an atomizer/pulverizer. The particle size of each aggregate is a value obtained by measuring the aggregate using a laser diffraction particle size distribution measurement apparatus, and the mean particle size is indicated as a median diameter.

40 parts by weight of the amorphous coke powder and 60 parts by weight of the acicular coke powder were blended to make an aggregate.

100 parts by weight of the aggregate was input to a kneading apparatus together with 70 parts by weight of a binder pitch and knead for 10 hours while being heated at 220°C. After cooling the kneaded mixture, the kneaded mixture was re-pulverized down to a maximum particle size of 250 $\mu$m to obtain a secondary powder for molding. The secondary powder was packed into a rubber case and molded under pressure of 1 t/cm$^2$ by cold isostatic pressing (CIP). The obtained compact was placed inside a firing furnace and subjected to a firing/carbonizing process up to 1000°C in a non-oxidizing atmosphere to obtain a fired body. The obtained fired body was impregnated with a pitch for impregnation and fired once again at 1000°C. The fired body was then transferred to a high frequency induction furnace (HF) to be heated up to 3000°C in a non-oxidizing atmosphere and graphitized to obtain a graphite material.

A plurality of pieces of a graphite base material were processed in a shape of a donut-type susceptor from the obtained graphite material. A graphite material test piece ($10 \times 10 \times 50$ mm) was cut out from one of the pieces of the graphite base material and physical property values thereof at room temperature were measured (Table 2).

A distribution of electrical resistivity was obtained by measuring electrical resistivity at 16 locations shown in Fig. 5 with respect to inside a plane of the graphite base material. The measurement of the electrical resistivity was performed using a resistivity meter (Loresta EP) manufactured by Dia Instruments Corporation. An average value $\rho_{av}$, a maximum value $\rho_{max}$, and a minimum value $\rho_{min}$ with respect to the obtained electrical resistivity are shown in Table 2. A variation ($\rho_{max}/\rho_{min}$) of electrical resistivity calculated using these results is shown in Table 3.

Characteristics of high-temperature electrical resistivity is shown (see Fig. 7) as a relative value ($\rho_t/\rho_0$) of each temperature with respect to room temperature using a resistance value measured by setting a graphite sample ($\phi 10 \times 100$ mm) cut out from the graphite base material to an apparatus shown in Fig. 6. A rate of high-temperature change ($\rho_{1600}/\rho_{800}$) of electrical resistivity calculated using the relative values at 800°C and 1600°C is shown in Table 3.

The graphite base material processed into a susceptor shape was placed in a purification furnace to be refined with $Cl_2$ gas at high temperature and then placed in a CVD furnace, and a SiC coating with a thickness of 100 $\mu$m (two coats of 50 $\mu$m) was formed on a surface of the graphite base material by introducing a mixture gas of $SiCl_4$ and $C_3H_8$ at high temperature together with an $H_2$ carrier gas to obtain a susceptor.

The susceptor was installed in an epitaxial growth apparatus (A), eleven(11) pieces of 4-inch sapphire substrates were placed on the susceptor, and a GaN coating was laminated over a process time of 8 hours by an MOCVD method to fabricate a wafer product (target wavelength 443 nm) for an LED.

An active layer of the obtained wafer product was measured at in-plane intervals of 1 × 1 mm by a photoluminescence (PL) analyzer, and averaging of PL wavelengths of the 11 sapphire substrates by statistical processing for each wafer yielded an average value of 443.8 nm and a standard deviation (STD) of 1.3. Repeated use of the susceptor revealed that the susceptor can be used in excess of 200 cycles.

Example 2

A susceptor was obtained by a same method as Example 1 with the exception of blending 50 parts by weight of an amorphous coke powder and 50 parts by weight of an acicular coke powder to make an aggregate.

Using this susceptor, a wafer product was fabricated according to a same procedure as Example 1 and PL wavelengths were measured. As a result, the PL wavelengths had an average value of 443.5 nm and a standard deviation of 1.4. Repeated use of the susceptor revealed that the susceptor can be used in excess of 200 cycles.

Example 3

As an aggregate raw material, a cutting powder of an artificial graphite material manufactured from acicular coke was pulverized by an atomizer/pulverizer to obtain an aggregate with a mean particle size of 70 $\mu$m.

A graphite material was obtained by a same method as Example 1 with the exception of blending 67 parts by weight of an amorphous coke powder and 33 parts by weight of the artificial graphite powder described above to make an aggregate and subjecting the obtained aggregate to a graphitizing process without impregnating the obtained fired body with pitch.

After obtaining a graphite base material processed into a susceptor shape from the graphite material, a susceptor was obtained by a same method as Example 1.

The susceptor was installed in an epitaxial growth apparatus (B), fourteen(14) pieces of 4-inch sapphire substrates were placed on the susceptor, and a GaN coating was laminated over a process time of 8 hours by an MOCVD method to fabricate a wafer product (target wavelength 443 nm) for an LED.

An active layer of the obtained wafer product was measured at in-plane intervals of 1 × 1 mm by a photoluminescence (PL) analyzer, and averaging of PL wavelengths of the 14 sapphire substrates by statistical processing for each wafer yielded an average value of 443.2 nm and a standard deviation of 1.6. Repeated use of the susceptor revealed that the susceptor can be used in excess of 200 cycles.

Example 4

A susceptor was obtained by a same method as Example 3 with the exception of blending 60 parts by weight of an amorphous coke powder and 40 parts by weight of an acicular coke powder to make an aggregate.

Using this susceptor, a wafer product was fabricated according to a same procedure as Example 3 and PL wavelengths were measured. As a result, the PL wavelengths had an average value of 443.6 nm and a standard deviation of 1.7. Repeated use of the susceptor revealed that the susceptor can be used in excess of 200 cycles.

Example 5

A susceptor was obtained by a same method as Example 3 with the exception of blending 70 parts by weight of an amorphous coke powder and 30 parts by weight of an acicular coke powder to make an aggregate.

Using this susceptor, a wafer product was fabricated according to a same procedure as Example 3 and PL wavelengths were measured. As a result, the PL wavelengths had an average value of 444.1 nm and a standard deviation (STD) of 1.8. Repeated use of the susceptor revealed that the susceptor can be used in excess of 200 cycles.

Comparative Example 1

A susceptor was obtained by a same method as Example 1 with the exception of: blending 60 parts by weight of a powder with a mean particle size of 5 μm obtained by pulverizing amorphous coke down to a maximum particle size of 30 μm with an atomizer/pulverizer and 40 parts by weight of a powder with a mean particle size of 50 μm obtained by pulverizing acicular coke down to a maximum particle size of 200 μm with an atomizer/pulverizer and subsequently removing a fine powder corresponding to 30% of an input amount with a classifier to make an aggregate; and subjecting an obtained fired body to a graphitizing process without impregnating the aggregate with pitch.
Using this susceptor, a wafer product was fabricated according to a same procedure as Example 1 and PL wavelengths were measured. As a result, the PL wavelengths had an average value of 447.8 nm and a standard deviation (STD) of 1.6, and since the PL wavelengths deviated from the target value described above, the wafer product was deemed defective. Therefore, use of the susceptor was discontinued.

Comparative Example 2

A susceptor was obtained by a same method as Example 1 with the exception of blending 80 parts by weight of an amorphous coke powder and 20 parts by weight of an acicular coke powder to make an aggregate.
Using this susceptor, a wafer product was fabricated according to a same procedure as Example 1 and PL wavelengths were measured. The PL wavelengths deviated from the target value described above and the wafer product was deemed defective. Therefore, use of the susceptor was discontinued.

Comparative Example 3

A susceptor was obtained by a same method as Example 3 with the exception of blending 50 parts by weight of an amorphous coke powder and 50 parts by weight of an acicular coke powder to make an aggregate, and after impregnating a fired body with pitch and firing the fired body once again at 1000°C, performing a graphitizing process in an Acheson furnace (AC) at 2500°C.
Using this susceptor, a wafer product was fabricated according to a same procedure as Example 3 and PL wavelengths were measured. Both the PL wavelengths and an STD deviated from the target value described above or a standard value and the wafer product was deemed defective. Since an SiC coating sustained breakage after one use, use of the susceptor was discontinued.

Comparative example 4

A susceptor was obtained by a same method as Example 4 with the exception of impregnating a fired body with pitch and firing the fired body once again at 1000°C and subsequently performing a graphitizing process at 2500°C.
Using this susceptor, a wafer product was fabricated according to a same procedure as Example 4 and PL wavelengths were measured. The PL wavelengths deviated from the target value described above and the wafer product was deemed defective. Therefore, use of the susceptor was discontinued.

Comparative example 5

A susceptor was obtained by a same method as Example 5 with the exception of impregnating a fired body with pitch and firing the fired body once again at 1000°C and subsequently performing a graphitizing process at 2500°C.
Although a wafer product was fabricated using the susceptor according to the same procedures as Example 5, even though the wafer product was nondefective, temperature responsiveness was poor, thereby forcing a reduction in process time to 10 hours.
Table 1 shows the used aggregates and the applied graphitizing conditions. Table 2 shows physical property values of the obtained graphite base materials. Table 3 compiles evaluation results of the obtained susceptors.

[Table 1]

| | Blending ratio of aggregate (wt%) | | | Mean particle size of aggregate (μm) | | | Graphitizing conditions | |
|---|---|---|---|---|---|---|---|---|
| | Amorphous coke powder (A) | Acicular coke powder (B) | Artificial graphite powder (C) | (A) | (B) | (C) | Temperature (°C) | Furnace |
| Example 1 | 40 | 60 | - | 15 | 15 | - | 3000 | HF |
| Example 2 | 50 | 50 | - | 15 | 15 | - | 3000 | HF |
| Example 3 | 67 | - | 33 | 15 | - | 70 | 3000 | HF |
| Example 4 | 60 | 40 | - | 15 | 15 | - | 3000 | HF |
| Example 5 | 70 | 30 | - | 15 | 15 | - | 3000 | HF |
| Comparative example 1 | 60 | 40 | - | 5 | 50 | - | 3000 | HF |
| Comparative example 2 | 80 | 20 | - | 15 | 15 | - | 3000 | HF |
| Comparative example 3 | 50 | 50 | - | 15 | 15 | - | 2500 | AC |
| Comparative example 4 | 60 | 40 | - | 15 | 15 | - | 2500 | HF |
| Comparative example 5 | 70 | 30 | - | 15 | 15 | - | 2500 | HF |

[Table 2]

| | Bulk density (g/cm³) | Coefficient of thermal expansion (×10⁻⁶/K) | Flexural strength (MPa) | Electrical resistivity (μΩm) | Electrical resistivity (μΩm) | | |
|---|---|---|---|---|---|---|---|
| | | | | | Pav | $\rho_{max}$ | $\rho_{min}$ |
| Example 1 | 1.73 | 3.9 | 35 | 8.6 | 8.8 | 9.0 | 8.9 |
| Example 2 | 1.79 | 4.0 | 46 | 10.0 | 10.1 | 10.3 | 9.9 |
| Example 3 | 1.73 | 4.3 | 43 | 11.8 | 11.7 | 11.9 | 11.7 |
| Example 4 | 1.77 | 4.1 | 54 | 12.3 | 12.3 | 12.4 | 12.0 |
| Example 5 | 1.79 | 4.2 | 60 | 12.8 | 12.7 | 12.9 | 12.3 |
| Comparative example 1 | 1.85 | 4.0 | 58 | 9.8 | 9.7 | 9.9 | 9.6 |
| Comparative example 2 | 1.85 | 4.5 | 56 | 10.1 | 10.2 | 10.4 | 10.0 |
| Comparative example 3 | 1.79 | 4.2 | 50 | 12.2 | 12.3 | 13.6 | 11.8 |
| Comparative example 4 | 1.82 | 4.3 | 52 | 12.9 | 12.9 | 13.2 | 12.8 |
| Comparative example 5 | 1.84 | 4.4 | 60 | 13.5 | 13.6 | 13.8 | 13.5 |

[Table 3]

| | Graphite base material | | Process time (h) | PL wavelength | | Useful life (cycles) | Overall evaluation |
|---|---|---|---|---|---|---|---|
| | $\rho_{max}/\rho_{min}$ | $\rho_{1600}/\rho_{800}$ | | Average value (nm) | Standard deviation STD | | |
| Example 1 | 1.01 | 1.27 | 8 | 443.8 | 1.3 | >200 | O |
| Example 2 | 1.04 | 1.24 | 8 | 443.5 | 1.4 | >200 | O |
| Example 3 | 1.02 | 1.20 | 8 | 443.2 | 1.6 | >200 | O |
| Example 4 | 1.03 | 1.17 | 8 | 443.6 | 1.7 | >200 | O |
| Example 5 | 1.05 | 1.14 | 8 | 444.1 | 1.8 | >200 | O |
| Comparative example 1 | 1.03 | 1.32 | 8 | 447.8 | 1.6 | * | X |
| Comparative example 2 | 1.04 | 1.11 | 8 | 448.2 | 1.5 | * | X |
| Comparative example 3 | 1.15 | 1.09 | 8 | 449.6 | 3.1 | ** | X |
| Comparative example 4 | 1.03 | 1.07 | 8 | 449.7 | 1.5 | * | X |
| Comparative example 5 | 1.02 | 1.05 | 10 | 443.5 | 1.6 | *** | X |

(Remarks)

\*: Deviation of PL wavelength from target value (443 nm) rendered wafer product defective, resulting in discontinuation of use of susceptor

\*\*: Wafer product deemed defective, and breakage of susceptor resulted in discontinuation of use of susceptor

\*\*\*: Productivity declined due to extended process time, resulting in discontinuation of use of susceptor O: Preferable wafer product with PL wavelength within prescribed range and superior productivity, and preferably usable as susceptor X: Unusable as susceptor

Results shown in Table 3 indicate that, with susceptors using a graphite base material within the range of the present invention of Examples 1 to 5, the PL wavelength (average value) of the wafer product manufactured according to a MOCVD method is within a target value range of 443 $\pm$3 nm and the standard deviation (STD) was less than 2, thereby satisfying quality standards.

In contrast, with Comparative example 1 of which a rate of high-temperature change ($\rho_{1600}/\rho_{800}$) of electrical resistivity is higher than 1.3 and Comparative examples 2, 3, and 4 of which a rate of high-temperature change ($\rho_{1600}/\rho_{800}$) of electrical resistivity is lower than 1.14, susceptor temperature failed to stabilize and PL wavelength deviated by $\pm$3 nm or more. In addition, with Comparative example 3 of which the variation ($\rho_{max}/\rho_{min}$) of electrical resistivity exceeded 1.05, a large variation in the temperature of the susceptor resulted in a large standard deviation (STD) in excess of 3 and, furthermore, thermal stress caused the coating to crack.

With Comparative example 5 of which a rate of high-temperature change ($\rho_{1600}/\rho_{800}$) of electrical resistivity is lower than 1.14, although responsiveness of the susceptor to temperature was low, quality as a wafer product was satisfied by extending the process time to 10 hours. However, a decline in productivity of the wafer product prevented the wafer product from being used for mass production.

[Industrial Applicability]

The present invention can be preferably utilized in a susceptor to be used when performing vapor phase epitaxial growth.

[Reference Signs List]

1       Susceptor
1A      Graphite sample (graphite base material)
5       Wafer
11      Wafer product
12      Sapphire substrate (wafer)


## Claims

**1.** A susceptor (1) that generates heat by induction heating, the susceptor (1) comprising:

a graphite base material (1A); and
a ceramic coating layer,
**characterized in that**
the graphite base material (1A) has a coefficient of thermal expansion of $3.5 \times 10^{-6}$/K or higher and $4.5 \times 10^{-6}$/K or lower, an electrical resistivity ($\rho_0$) of 8.0 $\mu\Omega\cdot$m or higher and 13.0 $\mu\Omega\cdot$m or lower, a bulk density of 1.70 to 1.80 g/cm$^3$ and a flexural strength of 35 to 60 MPa and exhibits a variation ($\rho_{max}/\rho_{min}$) of an in-plane electrical resistivity distribution at room temperature of 1.00 or higher and 1.05 or lower and a rate of high-temperature change ($\rho_{1600}/\rho_{800}$) of electrical resistivity at 1600°C to that at 800°C of 1.14 or higher and 1.30 or lower.

**2.** The susceptor (1) according to claim 1, wherein
the ceramic coating layer is at least one material selected from SiC, TaC, and PBN (pyrolytic boron nitride).


## Patentansprüche

**1.** Suszeptor (1), der Wärme durch Induktionserwärmung erzeugt, wobei der Suszeptor (1) umfasst:

ein Graphitbasismaterial (1A); und
eine keramische Beschichtung,
**dadurch gekennzeichnet, dass**
das Graphitbasismaterial (1A) einen Wärmeausdehnungskoeffizienten von $3,5 \times 10^{-6}$/K oder höher und $4,5 \times 10^{-6}$/K oder niedriger, einen spezifischen elektrischen Widerstand ($\rho_0$) von 8,0 $\mu\Omega\cdot$m oder höher und 13,0 $\mu\Omega\cdot$m oder niedriger, eine Rohdichte von 1,70 bis 1,80 g/cm$^3$ und eine Biegefestigkeit von 35 bis 60 MPa aufweist und eine Variation ($\rho_{max}/\rho_{min}$) der Verteilung des elektrischen Widerstandes in der Ebene bei Raumtemperatur von 1,00 oder höher und 1,05 oder niedriger und eine Rate der Hochtemperaturänderung ($\rho_{1600}/\rho_{800}$) des elektrischen Widerstandes bei 1600° C zu dem bei 800° C von 1,14 oder höher und 1,30 oder niedriger zeigt.

**2.** Suszeptor (1) nach Anspruch 1, wobei
die keramische Überzugsschicht aus mindestens einem Material besteht, das aus SiC, TaC und PBN (pyrolytisches Bornitrid) ausgewählt ist.


## Revendications

**1.** Un suscepteur (1) qui génère de la chaleur par chauffage par induction, le suscepteur (1) comprenant :

un matériau de base en graphite (1A) ; et
une couche de revêtement en céramique,
**caractérisé en ce que**
le matériau à base de graphite (1A) a un coefficient de dilatation thermique de $3,5 \times 10^{-6}$/K ou supérieur et de $4,5 \times 10^{-6}$/K ou inférieur, une résistivité électrique (po) de 8,0 $\mu\Omega\cdot$m ou supérieur et de 13,0 $\mu\Omega\cdot$m ou inférieur, une densité apparente de 1,70 à 1,80 g/cm$^3$ et une résistance à la flexion de 35 à 60 MPa et présente une variation ($\rho_{max}/\rho_{min}$) d'une distribution de résistivité électrique dans le plan à température ambiante de 1,00 ou plus et de 1,05 ou moins et un taux de changement à haute température ($\rho_{1600}/\rho_{800}$) de la résistivité électrique à 1600° C à celle à 800° C de 1,14 ou plus et de 1,30 ou moins.

2. Suscepteur (1) selon la revendication 1, dans lequel
la couche de revêtement céramique est au moins un matériau choisi parmi SiC, TaC et PBN (nitrure de bore pyrolytique).

[Fig. 1]

[Fig. 2]

[Fig. 3]

[Fig. 4]

[Fig. 5]

[Fig. 6]

[Fig. 7]

[Fig. 8]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1790757 A1
- JP H07165467 A
- JP 2004507619 W
- JP 2004281863 A

**Non-patent literature cited in the description**

- *TANSO,* 2015, vol. 268, 166-170
- Observation of Nitride Crystal Growth using In-situ Monitor. *11th Nitride Semiconductor Application Workshop,* 07 July 2011